# EUROPEAN PATENT SPECIFICATION

(11) **EP 1 008 041 B1**
(45) Date of publication and mention of the grant of the patent: **10.08.2005**
(21) Application number: 96937053.5
(22) Date of filing: 28.10.1996
(51) Int. Cl.: G06F 9/445, G06F 12/02, G06F 12/14, G06F 15/17, G06F 13/00, G11C 16/00

(54) **PROCESSOR WITH EMBEDDED IN-CIRCUIT PROGRAMMING STRUCTURES**
PROZESSOR MIT EINGEBETTETEN IN-CIRCUIT PROGRAMMIERUNGSSTRUKTUREN
PROCESSEUR AVEC STRUCTURES INTEGREES DE PROGRAMMATION EN-CIRCUIT

(43) Date of publication of application: 14.06.2000
(73) Proprietor: Macronix International Co., Ltd., Hsinchu (TW)
(72) Inventor: SUN, Albert C., Neihu, Taipeiaipei (TW); CHEN, Chang-Lun, Hsinchu (TW); LEE, Chee-Horng, Taipei (TW)
(74) Representative: Horner, David Richard
(86) International application number: PCT/US1996/017302
(87) International publication number: WO 1998/019234

(56) References cited:
- EP-A- 0 632 629
- EP-A- 0 681 298
- US-A- 5 018 096
- US-A- 5 163 147
- US-A- 5 349 697
- US-A- 5 444 664
- US-A- 5 444 861
- US-A- 5 467 286
- US-A- 5 579 479
- US-A- 5 581 723

## Description

### BACKGROUND OF THE INVENTION

### Field of the Invention

The present invention relates to integrated circuits having a non-volatile memory for storing sequences of instructions for execution by a processor on the integrated circuit; and more to particularly to techniques for accomplishing in-circuit programming to update and modify the stored sequences of instructions.

### Description of Related Art

Integrated circuit microcontrollers have been developed which include arrays of non-volatile memory on the chip for storing sequences of instructions to be executed by the microcontroller. The sequences of instructions can be stored in read only memory (ROM) which must be programmed during manufacturing of the device, and cannot be updated. In an alternative approach, the instructions can be stored in an EPROM array. These types of devices require a special programming device to be used to program the EPROM array before the device is placed in the circuit. In yet other systems, EEPROM memory can be used for storing the instructions. EEPROM can be programmed much more quickly than EPROM, and can be modified on the fly. Also, flash memory can be utilized, which allows for higher density and higher speed reprogramming of the non-volatile memory storing instructions. When the non-volatile memory is reprogrammable, such as EEPROM or flash memory, and it is combined with a microcontroller, the reprogramming of the device can be accomplished while the device is in the circuit, allowing in-circuit programming based on interactive algorithms.

For example, in the Internet environment, the ability to interactively download instruction sets and data to a remote device can be very valuable. For example, a company can provide service to customers without requiring the customer to bring the product back to a service center. Rather, the company can execute diagnostic functions using the in-circuit programming capability of the customer's device, across a communication channel, such as the Internet or telephone lines. Software fixes can be downloaded to the customer, and the product can be reenabled with corrected or updated code.

Example prior devices which include this capability include the AT89S8252 microcontroller, manufactured by Atmel of San Jose, California, and the P83CE558 single chip microcontroller, manufactured by Philips Semiconductors of Eindhoven, The Netherlands. According to the architecture of the Philips P83CE558 microcontroller, mask ROM is utilized for the in-circuit programming ICP set of instructions, which are used for updating flash memory on the chip. Thus, the Philips microcontroller requires a dedicated mask ROM module to store fixed ICP code for each individual environment. In order to adapt the ICP code for a particular environment, the environment must be known before manufacturing is complete of the device so the mask ROM can be coded. Furthermore, the ICP communication channel is fixed to a serial RS232 port in the Philips microcontroller. The limitation to a serial port limits the application of the microcontroller to relatively narrow range of potential applications, and makes it difficult to utilize the ICP function in a dynamic communication environment where the serial port may not match well with the communication channel on which the updated software is provided.

According to the architecture of the Atmel AT89S8252 microcontroller, a dedicated Serial Peripheral Interface (SPI) port on the chip is used for the updating of flash memory storing dynamically alterable instructions. Program logic is associated with the SPI port, and therefore is inflexible. Furthermore, modification of the in-circuit programming technique cannot be done because of the hardware dedication to the SPI port. Further disadvantages of the Atmel chip include that complicated hardware used for handshaking with the ICP initiator and emulating the erase/program/verify waveform for the flash memory must be added to the chip; that the SPI bus limitation is not always the best choice in diverse system applications, and that extra system logic is required to modify original reset circuits, which are implicated by the in-circuit programming algorithm. Further, complex SPI driver and receiver logic is required outside the chip in the system using the Atmel microcontroller.

Accordingly in-circuit programming structures have been developed which rely on flash memory or other dynamically alterable non-volatile memory. However, prior art approaches have been inflexible in the in-circuit algorithms used. Thus, in dynamic networking environments where communication requirements can change, and applications of devices using the in-circuit programming can proliferate through a wide variety of circumstances, it's desirable to provide more flexible in-circuit programming capability. Furthermore, the in-circuit programming capability must insure that no instructions are lost during the in-circuit programming process, even if the power is turned off during the process. The technique must allow for interactive communication with a remote partner to accomplish the in-circuit programming process. These techniques must be available over a wide variety of media, including the Intel/Microsoft/Digital standard Universal Serial Bus (USB), the Philips Electronics /Computer Access Technology standard Access Bus, the Apple Computer/IBM/AT & T standard Geoport, the Apple Computer/Texas Instruments/NCR standard 1349 FireWire, the Internet, a serial port (such as RS232), and other environments.

US-A-5,444,664 describes a microcomputer mounted on a single semiconductor chip which includes a central processing unit and a non-volatile flash memory which allows the information to be processed by the central processing unit to be re-programmed by electrical erasing and programming operations. A RAM is also provided for storing instructions to be executed on the central processing unit. US-A-5,467,286 describes a metering unit which is provided with a sector-erasable flash double EEPROM having a first section for storing main functionality firmware and a second section for storing boot code. The boot code includes a reset portion for resetting the metering unit and a firmware update section for downloading external firmware to the first section. The metering unit is also provided with a volatile RAM. The external firmware is downloaded to the first section of the EEPROM by executing the firmware update section of the boot code, and while executing the firmware update section, the writing routine is copied to the RAM and is executed therefrom to write the external firmware to the first section of the EEPROM.

Thus, it is desirable to provide more flexible in-circuit programming structures for use with integrated circuits.

### SUMMARY OF THE INVENTION

Particular and preferred aspects of the present invention are set out in the accompanying independent and dependent claims.

The present invention provides an architecture for an integrated circuit supporting in-circuit programming, which allows for dynamically altering the in-circuit programming instruction set itself, as well as other software stored on the chip. This greatly expands the usability of in-circuit programming devices to a wide variety of communication environments, supporting serial ports, parallel ports, telephone communications, Internet communications, and other communication protocols as suits the needs of a particular system. The invention is based on a microcontroller or other instruction executing processor on an integrated circuit having an embedded non-volatile memory array which stores instructions, including an in-circuit programming instruction set. In one embodiment, using a control program stored on the device, the device interactively establishes an in-circuit programming exchange with a remote partner, and updates data and software, including the in-circuit programming sequence, when needed. For example, a self-updating algorithm, according to an embodiment of the present invention, proceeds as follows:
1. The device receives an in-circuit programming request.
2. The initiator is identified.
3. The device returns an identifier back to the initiator of the request.
4. The information exchange proceeds when the parties have been successfully identified.
5. In order to begin the in-circuit programming, execution of the program jumps to an in-circuit programming routine in the non-volatile memory on the chip.
6. The in-circuit programming routine mirrors itself or at least an ICP kernel, to another bank of memory on the chip.
7. The in-circuit programming software disables itself and wakes up using the mirrored ICP sequence.
8. The mirrored ICP sequence downloads new in-circuit programming software to the original ICP location.
9. The mirrored ICP sequence disables itself, and wakes up with the new ICP software in the original flash array.
10. Normal program execution is then resumed.

New instructions and data for other parts of software stored in the flash memory device can be executed at numerous places in the sequences, relying on the original ICP code, the mirrored ICP code, or the new ICP code after it has been activated.

Accordingly, an embodiment of the present invention provides an apparatus for in-circuit programming of an integrated circuit having a processor which executes a program of instructions. The apparatus comprises a first memory array, comprising non-volatile memory cells, on the integrated circuit which stores instructions for execution by the processor, including in-circuit programming set of instructions. A second memory array also comprising non-volatile memory cells in preferred systems, is provided on the integrated circuit. One or more external ports is provided on the integrated circuit by which data is received from an external source. Control logic, including the processor and a kernel in the ICP code, is responsive to an in-circuit programming update command to write a copy of the in-circuit programming set from the first memory array to the second memory array, and to cause the processor to execute the in-circuit programming set from the second memory array to program the non-volatile memory cells of the first memory array with data from the external port.

According to one embodiment of the invention, the first memory array comprises a plurality of separately erasable blocks of non-volatile memory cells and the in-circuit programming set is stored in a particular block. During execution of the in-circuit programming set, the particular block is modified to generate a new in-circuit programming set. Then the control logic causes the processor to execute the new in-circuit programming set from the first memory array.

According to yet another embodiment of the invention, the integrated circuit includes a plurality of ports to external data sources, such as one or more serial ports, one or more parallel ports, and potentially one or more specialized communication ports. The port in the plurality of ports, as used for the external port during execution of the in-circuit programming set, is determined by the instructions in the in-circuit programming set itself, and thus, can be dynamically altered in one preferred embodiment of the present invention.

According to another embodiment of the invention, the integrated circuit includes a data path for programming and verifying the first memory array and optionally, the second memory array, independent of the in-circuit programming set of instructions. Thus, using multiplexed I/O pins or the like, original software can be loaded onto the device during manufacture or prior to mounting the chip into the system. In order to modify the original code, the in-circuit programming process is utilized.

An embodiment of the present invention provides a controller on an integrated circuit that includes a processor on the integrated circuit which executes instructions received at an instruction input to the processor module. First and second memory arrays of non-volatile memory cells are provided on the integrated circuit. The first memory array stores the in-circuit programming set of instructions in a particular block of non-volatile cells. An external port is provided on the integrated circuit by which data is received from an external source. Control logic, including the processor and a kernel in the ICP code, is responsive to an in-circuit programming update command to write a copy of the in-circuit programming set from the first memory array to the second memory array, and to cause the in-circuit programming set from the second memory to program the non-volatile memory cells of the first memory array with data received from external port. Data paths on the integrated circuit are provided for programming and verifying the first memory array, independent of the in-circuit programming set. The external port comprises in alternative embodiments, a serial port and a parallel port. In yet another embodiment, there are a plurality of external ports on the device, and the one selected for use during the in-circuit programming sequence is specified by the in-circuit programming software itself.

According to one embodiment, a method for in-circuit programming of an integrated circuit having a processor which executes a program of instructions is provided. The method includes:
1. providing on the integrated circuit a first erasable and programmable read only memory array and a second erasable and programmable read only memory array;
2. storing an in-circuit programming set of instructions in the first array;
3. receiving an in-circuit program command from an initiator external to the integrated circuit;
4. in response to the in-circuit program command, copying the in-circuit programming set from the first array to the second array, and executing with the processor the in-circuit programming set from the second array;
5. programming at least a selected portion of the first array with data from an external source under control of the in-circuit programming set; and
6. after programming the portion of the first array, executing with the processor the in-circuit programming set from the first array.

According to one embodiment of the present invention, the method includes storing the in-circuit programming set in the selected portion of the first memory array. Alternatively, the method can include the step of determining from the initiator whether the in-circuit programming sequence, indicated by the in-circuit programming command, includes modifying the in-circuit programming set. If the sequence does include the modification, then the step of copying and executing is carried out. If not, then the step of copying and executing is skipped, and the algorithm proceeds directly to programming the instructions and data in other portions of the memory array.

In sum, embodiments of the present invention provide an in-circuit programming technique which allows for dynamic alteration of the in-circuit programming sequences of instructions. This enables the use of the device in a wide variety of environments, and in dynamically changing environments. For example, if a communication protocol is updated, then the in-circuit programming sequence of instructions itself may need modification. According to embodiments of the present invention, a microcontroller can be placed in the field and dynamically updated as communication protocols are improved or speeds are increased. Furthermore, the device can be adapted for a wide variety of communications ports, allowing more widespread application of the microcontroller with in-circuit programming capability.

Other aspects and advantages of embodiments of the present invention can be seen upon review of the figures, the detailed description, and the claims that follow.

### BRIEF DESCRIPTION OF THE FIGURES

Fig. 1 is a schematic block diagram of an integrated circuit microcontroller, including the in-circuit programming structures of an embodiment of the present invention.
Figs. 2A - 2C are a flow chart of a preferred in-circuit programming process, according to an embodiment of the present invention.
**Fig. 3** is a flow chart of the update block routine which is called in the process of Figs. 2A - 2C.
Fig. 4 illustrates an environment of application of one embodiment of the present invention.

### DETAILED DESCRIPTION

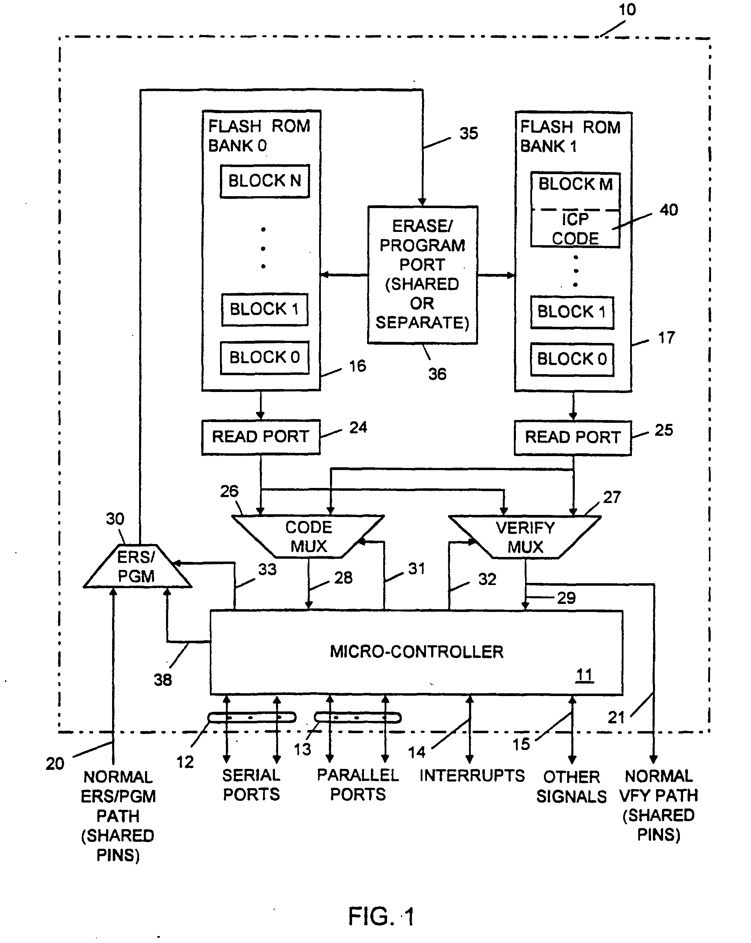

A detailed description of preferred embodiments of the present invention is provided with reference to Figs. 1, 2A - 2C, 3, and 4, in which Fig. 1 provides a hardware block diagram of the device.

Fig. 1 is a simplified diagram of an integrated circuit 10 having a processor, such as a microcontroller 11, embedded on the integrated circuit 10. Microcontroller 11 includes a plurality of serial ports 12, a plurality of parallel ports 13, interrupt pins 14, and other signal pins 15. For example, microcontoller 11 may be compatible with the standard 8051 microcontroller instruction set known in the art. A plurality of ports 12 and 13 are implemented on the device using standard interface technology. Alternative designs include special purpose ports on chip.

To support the in-circuit programming functionality of the present invention, a first array 16 of non-volatile memory and a second array 17 of non-volatile memory are embedded on integrated circuit 10. According to a preferred embodiment, first array 16 comprises flash ROM cells, which are implemented using floating gate memory cells, as known in the art. The first array includes a plurality of blocks of flash ROM cells, block 0 through block N, and is referred to as bank 0. Second array 17 also comprises flash ROM, and includes a plurality of blocks of cells, block 0 through block M and is referred to as bank 1.

The integrated circuit includes a normal path 20 for erase and programming of arrays 16 and 17 and a normal verify path 21 for verifying the erase and programming processes, as known in the art. In a preferred system, normal paths 20 and 21 are coupled to external circuits by I/O pins on integrated circuit 10. Furthermore, these I/O pins on integrated circuit 10 are multiplexed with other pins supporting ports 12, 13, interrupts 14, and other signals 15. Thus, for example, during a test mode or manufacturing mode, the normal erase and program path 20 and the normal verify path 21 are enabled, while other functions of the I/O chips are disabled. Techniques for accomplishing the multiplexed I/O pins are common in the art.

First array 16 and second array 17 include respective read ports 24 and 25, for providing instructions stored in the arrays to microcontroller 11. Thus, read port 24 is coupled to a code input multiplexer 26, and read port 25 is coupled to the code input multiplexer 26. In a similar fashion, both read ports 24 and 25 are coupled to a verify multiplexer 27 by which data in array 16 and array 17 is read during a verify procedure.

The output of the code multiplexer 26 is supplied to an instruction input 28 for microcontroller 11. The output of the verify multiplexer 27 is supplied to a read input 29 of microcontroller 11 and to normal verify path 21.

Normal erase/program path 20 is connected to an erase/program selector 30. A second input to selector 30 includes erase and program signals on line 38 from microcontroller 11. Microcontroller 11 controls multiplexer 26 and multiplexer 27 as indicated by lines 31 and 32. Also, microcontroller 11 controls selector 30, as indicated by line 33.

Erase/program selector 30 supplies the erase and program data and signals on line 35 to erase/program port 36 for first array 16 and second array 17. The erase/program port 36 includes logic and circuits used in the erase and program operation for the arrays, such as a control state machine, a high voltage generator, a negative voltage generator, timers and the like. In the preferred embodiment, a shared erase/program circuits are used for both first array 16 and second array 17. In an alternative, separate erase/program circuits are used for the separate non-volatile memory cells. The use of separate erase/program circuits may be preferred to simplify implementation of the device, at the cost of consuming chip area.

In the embodiment illustrated in Fig. 1, only two banks of flash ROM cells are illustrated. Alternative systems include more than two banks of flash ROM cells, allowing even greater flexibility in the design and implementation of in-circuit programming structures.

As illustrated in Fig. 1, memory arrays 16 and 17 store instructions which are executed by microcontroller 11. One portion of the instructions comprises an ICP kernel, referred to as an in-circuit programming set of instructions 40. The ICP kernel includes essential ICP code and/or system code that must be preserved during in-circuit programming processes. In the embodiment shown in Fig. 1, the in-circuit programming set is stored in block M of bank 1 of flash ROM array 17. In-circuit programming set 40 can be stored at any particular block in the device in any given implementation. Also, arrays 16 and 17 include a plurality of blocks of cells which are separately erasable, according to a segmented flash architecture, for example, such as that described in United States Patent No. 5,526,307, entitled FLASH EPROM INTEGRATED CIRCUIT ARCHITECTURE, invented by Yin, et al. Alternative embodiments include a plurality of separately erasable blocks in first array 16, and a single block in second array 17. Alternatively, a single block may be stored in each array. A wide variety of combinations of memory architectures can be implemented as suits the needs of a particular system.

Using the architecture of Fig. 1, designers of systems are enabled to adapt the in-circuit programming code to their particular environment. Thus, a manufacturer selects an integrated circuit, shown in Fig. 1, for implementation in their circuit. If the in-circuit programming code is not ready, the microcontroller is utilized and the variety of communication ports available on the chip are taken advantage of to minimize the extra logic needed on the circuit board with the microcontroller, to match the system to the particular in-circuit programming (ICP) environment envisioned. The proper connection and protocol for in-circuit programming is selected by the designer. The ICP code for the selected environment is developed and improved. Next, the ICP code is integrated with programs to be executed during normal operation of the system. Using normal erase and program path 20, the integrated ICP code and user code are stored in the flash memory arrays 16 and 17. Next, using normal verify path 21, the erase and program operations are verified. The smart microcontroller, having the integrated ICP code is then placed inside the system. The ICP procedure is executed and tested. If the ICP code works well, then the system is tested. If the system works well, then the system products can be mass produced. If the ICP code needs modification, then the process can be iteratively executed to optimize the ICP code. Similarly, the system code is optimized using the same techniques. The end user of the system developed by the manufacturer thus, has a robust in-circuit programming code embedded in the microcontroller, which can be updated and modified on the fly using the interactive in-circuit programming techniques, according to the present invention.

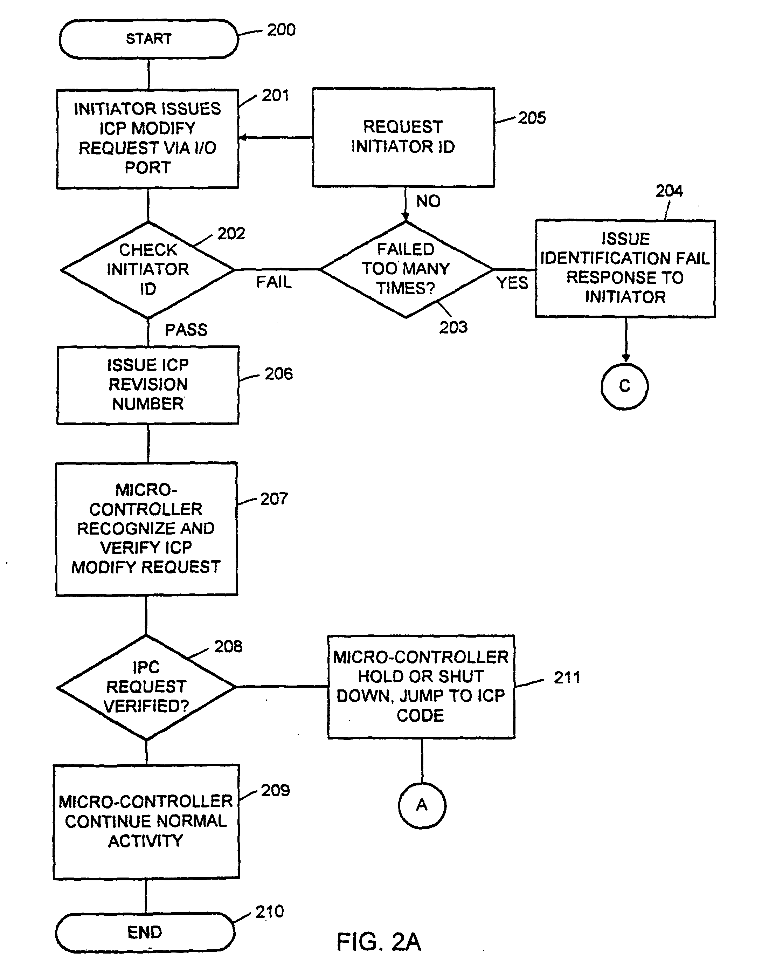

Figs. 2A - 2C illustrate the in-circuit programming techniques executed by end users, according to the present invention. The logic, according to Figs. 2A - 2C, is implemented by software executed by the microcontroller, by dedicated logic circuits, or by a combination of software and dedicated logic circuits.

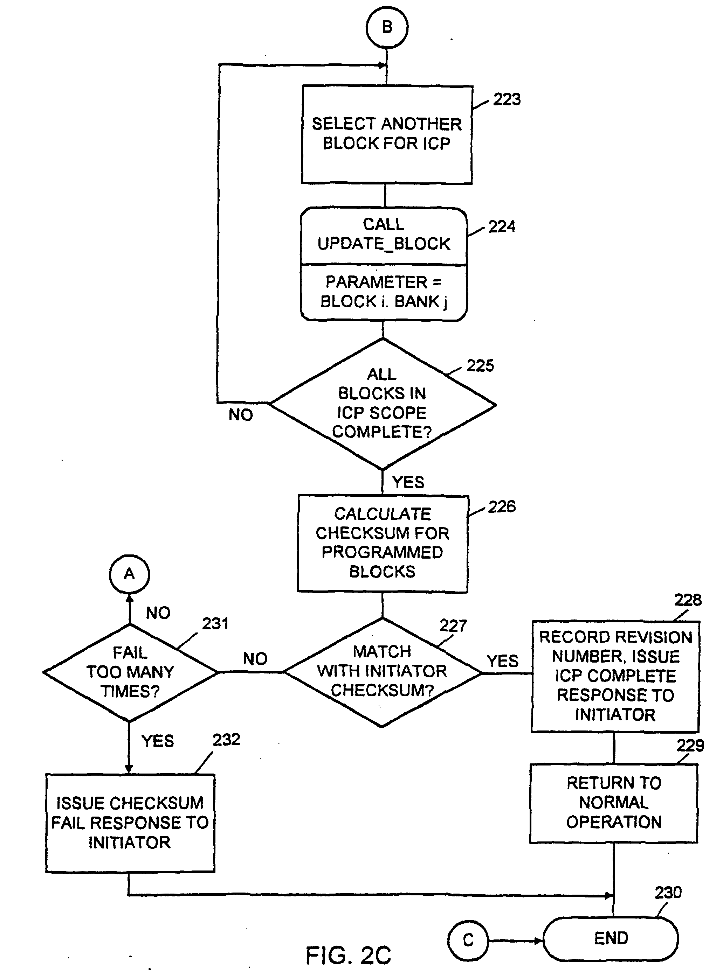

The process begins in Fig. 2A when a remote initiator desires to update or replace the in-circuit programming set of instructions or other software stored in one of the flash ROM banks of the integrated circuit, as indicated at point 200. A first step involves the initiator sending an ICP modify request via an I/O port on the integrated circuit (block 201). The microcontroller checks the identifier of the initiator, which is carried with the request. (block 202). If the identifier check fails, the algorithm determines whether a threshold number of failures has occurred (block 203). If the test has failed too many times, then the microcontroller issues an identification fail response to the initiator (block 204), and branches to point C in Fig. 2C. If the test of block 202 has not failed too many times, then the microcontroller issues an initiator indentifier request to the initiator (block 205), and branches to block 201. If the initiator identifier test of block 202 passes, the initiator or the microcontroller issues a revision number to identify the update (block 206). Next, the microcontroller recognizes and verifies the ICP modify request in the next step (block 207). For example, in one embodiment, the microcontroller issues an ICP identification command back to the ICP initiator. The initiator responds with an acknowledgment to open an ICP communication channel.

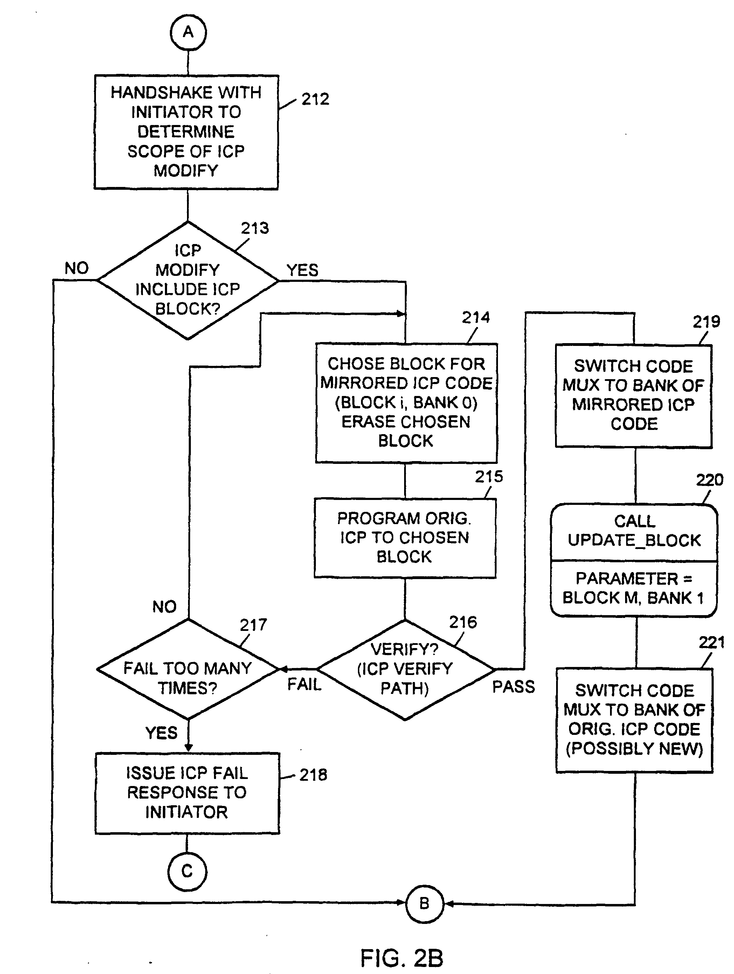

In the next step, the microcontroller determines whether the ICP modify request has been verified (block 208). If the request is not verified, then the microcontroller continues with normal activity (block 209) and the sequence ends (block 210). If the ICP modify request is verified, then the microcontroller executes a trap to the ICP code (block 211). Thus, the microcontroller holds its current status, shuts down normal activities, and jumps to the ICP code, to begin getting ready for an in-circuit programming sequence. The process continues to point A in Fig. 2B.

The first step in Fig. 2B involves a handshake protocol with the initiator to determine the scope of the ICP modify sequence (block 212). For example, the ICP modify sequence may involve one block or many blocks in the first and second arrays in the integrated circuit. Also, the handshake protocol determines whether the ICP code itself is subject of the modify operation. Thus, the next step determines whether the ICP block is included in the modify sequence (block 213). If the ICP block is not included in the modify sequence, then the algorithm proceeds to point B as indicated, which picks up in Fig. 2C. If the ICP modify sequence does include the ICP block, then the ICP logic chooses a block for storing mirrored ICP code (block i bank 0 in the embodiment where the ICP code is originally stored in bank 1). Upon choosing the block in which to mirror the ICP code, the chosen block is erased (block 214). Next, the original ICP code is programmed into the chosen block in bank 0 (block 215).

After the program sequence, a verify operation is executed (block 216). If the verify sequence fails, then the algorithm determines whether the program of the ICP block has failed too many times (block 217). If not, then the program of the ICP block is retried by looping to block 214. If the sequence has failed too many times, then the logic issues an ICP fail response to the initiator (block 218), and branches to point C in Fig. 2C.

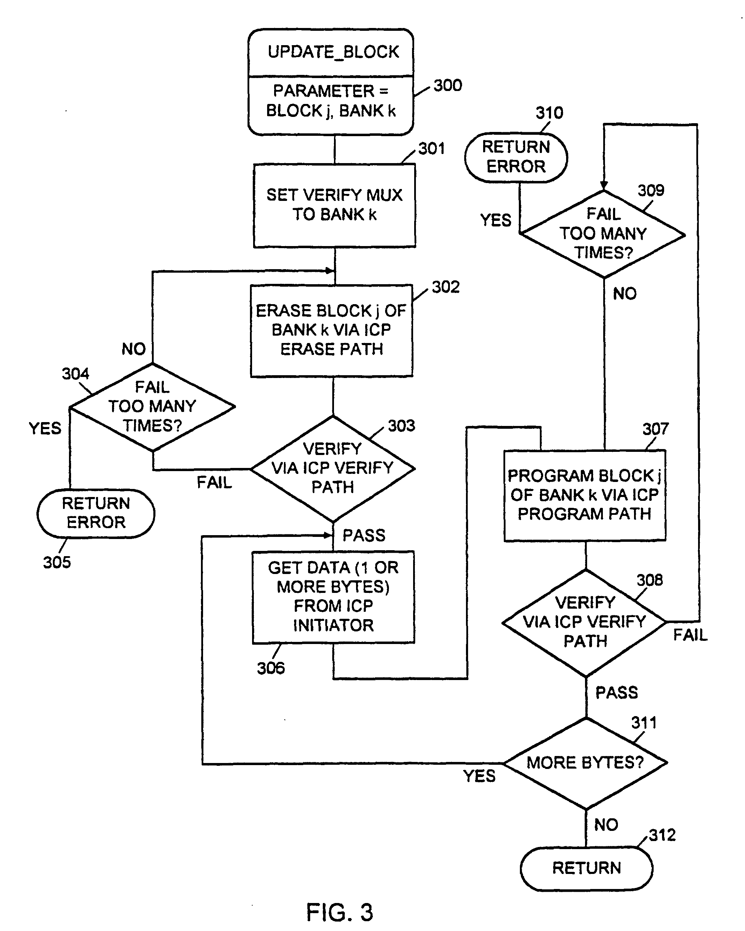

If at block 216, the verify procedure passes, then the code multiplexer (e.g., multiplexer 26 of Fig. 1) is switched to select instructions from the bank in which the mirrored ICP code is stored (block 219). Mirrored ICP code is executed, and a call to the update block routine with the parameters set for block M of bank 1, is made (block 220). The update block routine is illustrated in Fig. 3, and results in updating block M of bank 1, with possibly new ICP code. After step 215, the code multiplexer is switched back to the original bank, bank 1, storing the possibly new ICP code (block 221). The algorithm then proceeds to point B of Fig. 2C.

In Fig. 2C, the next step involves selecting another block for the ICP procedure, if any (block 223). After selecting another block, the update block is called with a parameter set at block i, bank j, indicating the selected block (block 224). The algorithm next determines whether all blocks in the in-circuit programming sequence are completed (block 225). If yes, then a checksum is calculated for all programmed blocks (block 226). If no at block 225, then the algorithm loops to block 223. The loop continues until all blocks in the determined scope of the in-circuit programming procedure have been completed. After completion of the ICP procedure, a checksum is calculated for all programmed blocks (block 226). A protocol is initiated to match the calculated checksum with the checksum provided by the initiator (block 227). If a match occurs, then the microcontroller records the revision number, and issues an ICP complete response to the initiator (block 228). Then the microcontroller returns to normal operation (block 229), and the algorithm ends (block 230). If the checksum does not match at block 227, then the algorithm determines whether the ICP sequence has failed too many times (block 231). If it has not failed too many times, then the algorithm loops to point A of Fig. 2A, to retry the ICP sequence. If the ICP sequence has failed too many times, then the algorithm issues an ICP fail response to the initiator (block 232) and the procedure ends (block 230).

The update block procedure is illustrated in Fig. 3. Thus, the update block procedure is called with a parameter set, for instance block j, bank k (block 300). The sequence sets the verify multiplexer to select bank k for the verify path (block 301). Next block j of bank k is erased using the ICP erase path (block 302). After the erase process, a verify sequence is executed (block 303). If the verify fails, then it is determined whether the erase procedure has failed too many times (block 304). If not, then the algorithm loops back to block 302 to retry the erase. If it has failed too many times, then an error is returned (block 305). After successful verify from block 303, data is retrieved from the ICP initiator (block 306). The data from the ICP initiator may be one or more bytes of data depending on the ICP protocol selected by the user.

After retrieving the data from the ICP initiator, the algorithm programs block j of bank k via the ICP program path (block 307). After the program sequence, a verify operation is executed (block 308). If the program verify fails, then it is determined whether the fail has occurred too many times (block 309). If it has failed too many times, then an error is returned (block 310). If the verify has not failed too many times, then the program is retried by looping to block 307. If at block 308 the verify succeeds, then it is determined whether the ICP sequence includes more data for programming into block j of bank k (block 311). If yes, then the algorithm loops to block 306 to retrieve the next sequence of data for programming. If no more bytes remain, then the algorithm returns (block 312).

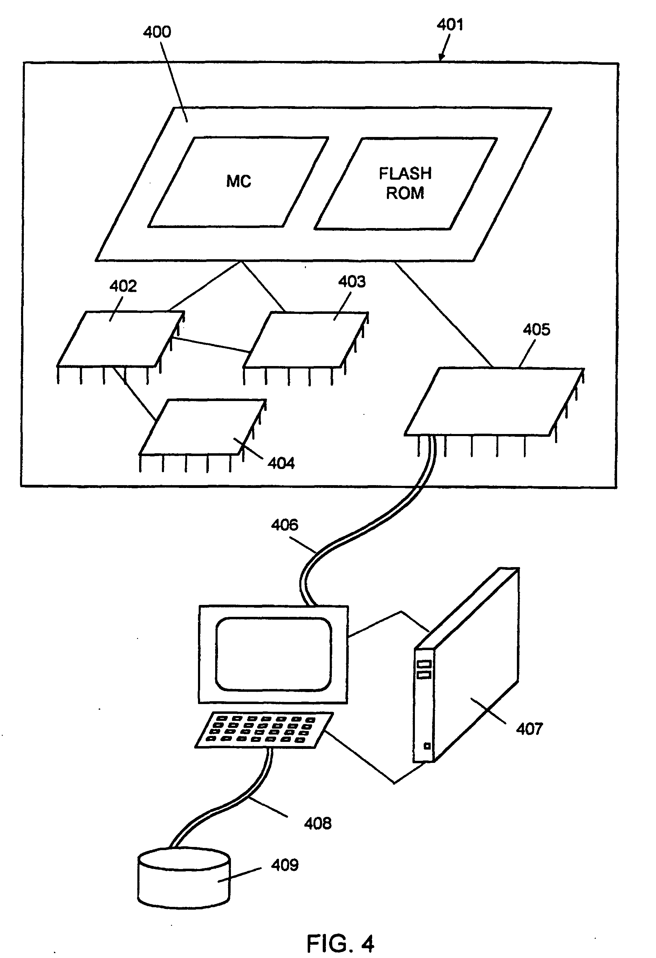

Fig. 4 illustrates the environment of application of the present invention. The present invention is implemented on an integrated circuit 400 which is placed on a printed circuit board 401 or other system implementation. The microcontroller 400 is coupled to a plurality of integrated circuits 402, 403, 404, and/or 405, in the system in which it is utilized. Chip 405 provides a bridge to a communication channel across which ICP programming is achieved. Chip 405 may comprise a simple network port, or may include extra glue logic, to make the ICP solution transparent to existing system behavior. The character of port chip 405 will be different in different applications. Chip 405 may be coupled to diverse ICP communication channels having different levels of data rates, error rates, and complexity. For example, the communication channel 406, in one embodiment, comprises an Internet protocol. Channel 406 is coupled to an ICP initiator 407, such as a personal computer or workstation. Workstation 407 is coupled by a network or other communication channel 408 to a large scale storage 409. For example, workstation 407 may be a World Wide Web site accessed through the Internet on channel 406. Alternatively, in other systems, workstation 407 acts as the initiator across a dial-up modem link. In another alternative, communication link 406 is a communication bus in a personal computer, and the in-circuit software is loaded across the bus 406, so that the upgrades to system 401 can be distributed to end users on floppy disks or otherwise in loaded through personal computer 407.

Accordingly, the present invention provides a smart and flexible flash memory-based microcontroller architecture which allows for diverse in-circuit programming applications. For example, televisions or video monitors, digital video disks or CD-ROMs, remote control devices, or mobile telephones may include microcontrollers with in-circuit programming structures, according to the present invention. Various sources of updated ICP code can then be loaded into the respective devices using the flexible architecture of the present invention. The single in-circuit programming architecture of the present invention can be utilized in a wide variety of applications. Very little or no glue logic is needed in order to support the in-circuit programming structures. Furthermore, the power of the microcontroller associated with the in-circuit programming can be leveraged to increase the flexibility and to customized to ICP protocol for a given environment.

The foregoing description of a preferred embodiment of the invention has been presented for purposes of illustration and description. It is not intended to be exhaustive or to limit the invention to the precise forms disclosed. Obviously, many modifications and variations will be apparent to practitioners skilled in this art. It is intended that the scope of the invention be defined by the following claims and their equivalents.

## Claims

1. An apparatus for in-circuit programming of an integrated circuit (10) having a processor (11) which executes a program of instructions, comprising:
a first memory array (17) comprising non-volatile memory cells on the integrated circuit which stores instructions for execution by the processor, including an in-circuit programming set of instructions (40) for programming the first memory array;
a second memory array (16) comprising non-volatile memory cells on the integrated circuit which stores instructions for execution by the processor;
an external port (12, 13) on the integrated circuit by which data is received from an external source; and
control logic, responsive to an in-circuit program update command, to write a copy of the in-circuit programming set (40) from the first memory array (17) to the second memory array (16), and to cause the processor (11) to execute the in-circuit programming set from the second memory array (16) to program non-volatile memory cells of the first memory array (17) with data from the external port in order to update at least the in-circuit programming set of instructions stored in the first memory array, whereafter the control logic is operable to cause the processor to execute the updated in-circuit programming set of instructions stored in the first memory array.

2. The apparatus of claim 1, wherein the first memory array (17) comprises a plurality of separately erasable blocks of non-volatile memory cells, and the in-circuit programming set is stored in a particular block in the plurality of blocks, and wherein during execution of the in-circuit programming set from the second memory array (16), the particular block is modified to generate a new in-circuit programming set, and then the control logic is operable to cause the processor to execute the new in-circuit programming set from the first memory array.

3. The apparatus of claim 1, including:
a data path (20, 21) for programming and verifying the first memory array independent of the in-circuit programming set.

4. The apparatus of claim 1, wherein the control logic includes instructions executed by the processor (11).

5. The apparatus of claim 1, including a plurality of ports (12, 13) to external data sources, and wherein the in-circuit program update command is received at one of the plurality of ports.

6. The apparatus of claim 5, wherein the port in the plurality of ports used for the external port, and the port in the plurality of ports at which the in-circuit program update command is received, are determined by instructions in the in-circuit programming set (40).

7. The apparatus of claim 1, wherein the non-volatile memory cells in the first memory array (17) comprise floating gate memory cells, and the second memory array (16) comprises floating gate memory cells, and including:
an erase and program port (36) coupled to the first and second memory arrays, which provides for erasing and programming the first and second memory arrays.

8. The apparatus of claim 7, wherein the erase and program port (36) includes erase and program circuits connected in common to the first and second memory arrays.

9. The apparatus of claim 7, wherein the erase and program port (36) includes separate erase and program circuits for each of the first and second memory arrays.

10. The apparatus of claim 1, further comprising:
a code multiplexer (26) having a first input coupled to the first memory array (17), a second input coupled to the second memory array (16), and an output (28) to feed the processor (11) with instructions;
an erase/program multiplexer (30) which supports a first erase/program path (20) for programming and erasing at least the first memory array (17) to load at least the first memory array with instructions, and a second erase/program path (38) for programming and erasing at least the first memory array (17) under control of the in-circuit programming set of instructions (40); and
logic including the in-circuit programming set of instructions stored in the first memory array and the processor, responsive to the in-circuit program update command to update all or part of the instructions stored in the first memory array and in the second memory array.

11. The apparatus of claim 10, wherein the in-circuit programming set of instructions includes logic to:
write a copy of the original in-circuit programming set (40) from the first memory array (17) to the second memory array (16) to create a mirrored in-circuit programming set;
control the code multiplexer (26) to switch the processor (11) control from the original in-circuit programming set to the mirrored in-circuit programming set in the second memory array; and
update the in-circuit programming set in the first memory array under the control of the mirrored in-circuit programming set in the second memory array.

12. The apparatus of claim 10, including program and erase circuits (36) coupled in common to the first and second memory arrays.

13. The apparatus of claim 10, wherein the first memory array (17) comprises a plurality of separately erasable blocks of non-volatile memory cells.

14. The apparatus of claim 10, including a plurality of ports (12, 13) to external data sources, and wherein the in-circuit program update command is received at one of the plurality of ports.

15. The apparatus of claim 14, wherein the port in the plurality of ports used for the external port, and the port in the plurality of ports at which the in-circuit program with data command is received are determined by instructions in the in-circuit programming set (40).

16. The apparatus of claim 1, including program and erase circuits (36) coupled in common to the first and second memory arrays.

17. The apparatus of claim 1, wherein the first memory array (17) comprises a plurality of separately erasable blocks of non-volatile memory cells.

18. The apparatus of claim 1, wherein the first memory array (17) comprises flash erasable and programmable read only memory.

19. The apparatus of claim 1 or claim 10, wherein the non-volatile memory cells in first memory array (17) comprise floating gate memory cells.

20. The apparatus of claim 2 or claim 10, wherein the non-volatile memory cells in first memory array (17) and in the second memory array (16) comprise floating gate memory cells.

21. The apparatus of claim 1 or claim 10, wherein the first memory array (17) and the second memory array (16) comprise flash erasable and programmable read only memory.

22. The apparatus of claim 1 or claim 10, wherein the external port comprises a serial port (12).

23. The apparatus of claim 1 or claim 10, wherein the external port comprises a parallel port (13).

24. The apparatus of claim 1 or claim 10, including a plurality of ports (12, 13) to external set data sources, and wherein the port in the plurality of ports used for the external port during execution of the in-circuit programming set is determined by the instructions in the in-circuit programming set (40).

25. The apparatus of claim 1, wherein:
the processor (11) on the integrated circuit (10) has an instruction input (28), and executes instructions received at the instruction input;
the first memory array (17) comprises non-volatile memory cells on the integrated circuit having a read port (25) coupled to the instruction input of the processor, and a block of non-volatile memory cells storing the in-circuit programming set of instructions (40);
the second memory array comprises non-volatile memory cells on the integrated circuit having a read port (24) coupled to the instruction input of the processor; and
the apparatus further comprising data paths (20, 21), on the integrated circuit, for programming and verifying the first memory array independent of the in-circuit programming set.

26. The apparatus of claim 25, wherein the non-volatile memory cells in first memory array (17) and in the second memory array (16) comprise floating gate memory cells.

27. The apparatus of claim 25, wherein the first memory array (17) comprises a plurality of separately erasable blocks of non-volatile memory cells, and the in-circuit programming set is stored in a particular block in the plurality of blocks, and wherein during execution of the in-circuit programming set from the second memory array (16), the particular block is modified to generate a new in-circuit programming set, and then the control logic is operable to cause the processor to execute the new in-circuit programming set from the first memory array.

28. The apparatus of claim 25, wherein the first memory array (17) and the second memory array (16) comprise flash erasable and programmable read only memory.

29. The apparatus of claim 25, wherein the control logic includes instructions executed by the processor (11).

30. The apparatus of claim 25, wherein the external port comprises a serial port (12).

31. The apparatus of claim 25, wherein the external port comprises a parallel port (13).

32. The apparatus of claim 25, including a plurality of ports (12, 13) to external data sources, and wherein the port in the plurality of ports used for the external port during execution of the in-circuit programming set is determined by the instructions in the in-circuit programming set (40).

33. The apparatus of claim 25, wherein the non-volatile memory cells in first memory array (17) comprise floating gate memory cells, and the second memory array (16) comprises floating gate memory cells, and including:
an erase and program port (36) coupled to the first and second memory arrays, which provides for erasing and programming the first and second memory arrays.

34. The apparatus of claim 33, wherein the erase and program port (36) includes erase and program circuits connected in common to the first and second memory arrays.

35. The apparatus of claim 33, wherein the erase and program port (36) includes separate erase and program circuits for each of the first and second memory arrays.

36. A method for in-circuit programming of an integrated circuit (10) having a processor (11) which executes a program of instructions, comprising the steps of:
providing on the integrated circuit a first memory array (17) comprising non-volatile memory cells and a second memory array (16) comprising non-volatile memory cells;
storing an in-circuit programming set of instructions (40) in the first array;
receiving (201) an in-circuit program command from an initiator external to the integrated circuit;
in response to the in-circuit program command, copying (215) the in-circuit programming set (40) from the first array (17) to the second array (16), and executing (219) with the processor the in-circuit programming set from the second array;
programming (220) at least a selected portion of the first array with data from an external source under control of the in-circuit programming set from the second array in order to update at least the in-circuit programming set of instructions stored in the first array; and
after programming the portion of the first array, executing (221) with the processor the updated in-circuit programming set from the first array (17).

37. The method of claim 36, wherein the first array (17) comprises a plurality of separately erasable blocks of cells, and the selected portion of the first array comprises a particular block in the plurality of blocks, and the step of programming (220) the portion of the first array includes modifying the particular block to generate a new in-circuit programming set.

38. The method of claim 37, including:
after modifying the particular block, executing (221) the new in-circuit programming set from the first memory array.

39. The method of claim 36, further comprising the steps of:
at said receiving step (201), additionally receiving an identifier from the initiator external to the integrated circuit;
verifying (202) the identifier of the initiator, and if verified then in response to the in-circuit program command, performing said copy step (215) to copy the in-circuit programming set from the first array to the second array, and performing said executing step (219) to execute with the processor the in-circuit programming set from the second array (16).

40. The method of claim 39, including:
if the identifier of the initiator is not verified, then requesting (205) identification from the initiator, and attempting to verify (202) the identification of the initiator until verification succeeds, or until a maximum number of attempts has been made (203); and
if the maximum number of attempts is made, then issuing (204) a fail response to the initiator.

41. The method of claim 39, including:
issuing (206) a revision number to identify the instruction set, and storing (228) the revision number if the step of programming succeeds.

42. The method of claim 39, including:
after the step of programming, checking (227) the programmed instruction set for errors, and if an error is found, then retrying the programming step until no errors are found or until a maximum number of retries has been attempted (231); and
if the maximum number of retries is attempted, then issuing (232) a fail response to the initiator.

43. The method of claim 42, wherein the step of checking the programmed instruction set for errors includes verifying (227) a checksum for the programmed instruction set.

44. The method of claim 39, wherein the step of programming includes programming (307) a segment of the instruction set, and verifying (308) programming of the segment, and if the programming of the segment is verified, proceeding (311) to a next segment until the instruction set is completed, and if the programming of the segment is not verified, then retrying the programming until it passes verify or until a maximum number of retries has been attempted (309);
if the maximum number of retries is attempted without passing verify, then issuing (310) a fail response to the initiator.

45. The method of claim 39, wherein the first array (17) comprises a plurality of separately erasable blocks of cells, and the selected portion of the first array comprises a particular block in the plurality of blocks, and the step of programming (220) the portion of the first array includes modifying the particular block to generate a new in-circuit programming set.

46. The method of claim 45,including:
after modifying the particular block, executing (221) the new in-circuit programming set from the first memory array.

47. The method of claim 36 or claim 39, wherein the step of storing the in-circuit programming set includes storing the in-circuit programming set in the selected portion of the first array (17).

48. The method of claim 36 or claim 39, including:
determining from the initiator whether the in-circuit programming sequence indicated by the in-circuit programming command includes modifying (213) the in-circuit programming set, and if not, then skipping the step of copying and executing the in-circuit programming set from the second array.

49. The method of claim 36 or claim 39, wherein the integrated circuit includes a plurality of ports (12, 13) to external sources of data, and the step of programming includes receiving data from a selected port of the plurality of ports.

50. The method of claim 49, wherein the selected port is specified by the in-circuit programming set (40).

51. The method of claim 36 or claim 39, wherein the first array (17) and the second array (16) comprise erasable and programmable read only memory cells.

## Patentansprüche

1. Vorrichtung für das Programmieren eines integrierten Schaltkreises (10) innerhalb des Schaltkreises selbst, mit einem Prozessor (11), der ein aus Befehlen bestehendes Programm ausführt, und welche aufweist:
ein erstes Speicherarray (17), welches nicht-flüchtige Speicherzellen auf dem integrierten Schaltkreis aufweist und welches Befehle für die Ausführung durch den Prozessor speichert, einschließlich eines schaltkreisintemen Programmiersatzes von Befehlen (40) zum Programmieren des ersten Speicherarrays,
ein zweites Speicherarray (16), das nicht-flüchtige Speicherzellen auf dem integrierten Schaltkreis aufweist und das Befehle für die Ausführung durch den Prozessor speichert,
einen externen Anschluß (12, 13) auf dem integrierten Schaltkreis, durch welchen Daten von einer externen Quelle empfangen werden, und
eine Steuerschaltung, die auf einen Aktualisierungsbefehl für das schaltkreisinterne Programm reagiert, um eine Kopie des schaltkreisintemen Programmiersatzes (40) aus dem ersten Speicherarray (17) in das zweite Speicherarray (16) zu schreiben, und um zu veranlassen, daß der Prozessor (11) den schaltkreisinternen Programmiersatz aus dem zweiten Speicherarray (16) ausführt, um nicht-flüchtige Speicherzellen des ersten Speicherarrays (17) mit Daten aus dem externen Anschluß zu programmieren, um zumindest den schaltkreisinternen Programmiersatz von Befehlen, der in dem ersten Speicherarray gespeichert ist, zu aktualisieren, woraufhin die Steuerlogik so betreibbar ist, daß sie veranlaßt, daß der Prozessor den aktualisierten schaltkreisinternen Programmiersatz von Befehlen ausführt, welcher in dem ersten Speicherarray gespeichert ist.

2. Vorrichtung nach Anspruch 1, wobei das erste Speicherarray (17) eine Mehrzahl von getrennt löschbaren Blöcken nicht-flüchtiger Speicherzellen aufweist, und wobei der schaltkreisinteme Programmiersatz in einem besonderen Block in der Mehrzahl von Blöcken gespeichert ist, und wobei während der Ausführung des schaltkreisinternen Programmiersatzes aus dem zweiten Speicherarray (16) der spezielle Block modifiziert wird, um einen neuen schaltkreisintemen Programmiersatz zu erzeugen, wobei dann die Steuerlogik in der Weise betreibbar ist, daß sie den Prozessor veranlaßt, den neuen schaltkreisinternen Programmiersatz aus dem ersten Speicherarray auszuführen.

3. Vorrichtung nach Anspruch 1, mit:
einem Datenpfad (20, 21) zum Programmieren und Verifizieren des ersten Speicherarrays unabhängig von dem schaltkreisinternen Programmiersatz.

4. Vorrichtung nach Anspruch 1, wobei die Steuerlogik durch den Prozessor (11) ausgeführte Befehle enthält.

5. Vorrichtung nach Anspruch 1, einschließlich einer Mehrzahl von Anschlüssen (12, 13) zu externen Datenquellen, wobei der schaltkreisinteme Befehl zur Programmaktualisierung an einem der Mehrzahl von Anschlüssen empfangen wird.

6. Vorrichtung nach Anspruch 5, wobei der Anschluß in der Mehrzahl von Anschlüssen, welcher für den externen Anschluß verwendet wird, und der Anschluß in der Mehrzahl von Anschlüssen, an welchem der Befehl zur Aktualisierung des schaltkreisintemen Programms empfangen wird, durch Befehle in dem schaltkreisintemen Programmiersatz (40) bestimmt werden bzw. sind.

7. Vorrichtung nach Anspruch 1, wobei die nicht-flüchtigen Speicherzellen in dem ersten Speicherarray (17) Speicherzellen mit Floating-Gate aufweisen und wobei das zweite Speicherarray (16) Speicherzellen mit Floating-Gate aufweist, und mit:
einem Lösch- und Programmieranschluß (16), der mit den ersten und zweiten Speicherarrays verbunden ist, was ein Löschen und Programmieren der ersten und zweiten Speicherarrays gewährleistet.

8. Vorrichtung nach Anspruch 7, wobei der Lösch- und Programmieranschluß (36) Lösch- und Programmierschaltkreise umfaßt, die gemeinsam mit den ersten und zweiten Speicherarrays verbunden sind.

9. Vorrichtung nach Anspruch 7, wobei der Lösch- und Programmieranschluß (36) getrennte Lösch- und Programmierschaltkreise für jedes der ersten und zweiten Speicherarrays aufweist.

10. Vorrichtung nach Anspruch 1, welche weiterhin aufweist:
einen Codemultiplexer (26), welcher einen ersten Eingang hat, der mit dem ersten Speicherarray (17) verbunden ist, einen zweiten Eingang hat, der mit dem zweiten Speicherarray (16) verbunden ist, und einen Ausgang (28) hat, um den Prozessor (11) mit Befehlen zu versorgen,
einen Lösch-/Programmiermultiplexer (30), der einen ersten Lösch-/Programmierpfad (20) zum Programmieren und Löschen zumindest des ersten Speicherarrays (17) unterstützt, um zumindest das erste Speicherarray mit Befehlen zu laden, und einen zweiten Lösch-/Programmierpfad (38) zum Programmieren und Löschen zumindest des ersten Speicherarrays (17) unter der Steuerung des schaltkreisintemen Programmiersatzes von Befehlen (40) hat, und
eine Logik, welche den schaltkreisintemen Programmiersatz von Befehlen, welcher in dem ersten Speicherarray gespeichert ist, und den Prozessor umfaßt, und welche auf den Befehl zum Aktualisieren des schaltkreisintemen Programms reagiert, um alle oder einen Teil der Befehle, welche in dem ersten Speicherarray und in dem zweiten Speicherarray gespeichert sind, zu aktualisieren.

11. Vorrichtung nach Anspruch 10, wobei der schaltkreisinteme Programmiersatz von Befehlen eine Logik aufweist, um
eine Kopie des ursprünglichen schaltkreisintemen Programmiersatzes (40) aus dem ersten Speicherarray (17) in das zweite Speicherarray (16) zu schreiben, um einen gespiegelten schaltkreisintemen Programmiersatz zu erzeugen,
den Codemultiplexer (26) so zu steuern, daß er die Steuerung des Prozessors (11) von dem ursprünglichen schaltkreisinternen Programmiersatz auf den gespiegelten schaltkreisinternen Programmiersatz in dem zweiten Speicherarray umschaltet, und
den schaltkreisintemen Programmiersatz in dem ersten Speicherarray unter der Steuerung des gespiegelten schaltkreisintemen Programmiersatzes in dem zweiten Speicherarray aktualisiert.

12. Vorrichtung nach Anspruch 10, welche Programmier- und Löschschaltkreise (36) aufweist, die gemeinsam mit den ersten und zweiten Speicherarrays verbunden sind.

13. Vorrichtung nach Anspruch 10, wobei das erste Speicherarray (17) eine Mehrzahl von getrennt löschbaren Blöcken nicht-flüchtiger Speicherzellen aufweist.

14. Vorrichtung nach Anspruch 10, einschließlich einer Mehrzahl von Anschlüssen (12, 13) zu externen Datenquellen, wobei der Befehl zur schaltkreisinternen Programmaktualisierung an einem aus der Mehrzahl von Anschlüssen empfangen wird.

15. Vorrichtung nach Anspruch 14, wobei der Anschluß in der Mehrzahl von Anschlüssen, welcher für den externen Anschluß verwendet wird, und der Anschluß in der Mehrzahl von Anschlüssen, an welchem der Befehl zur schaltkreisintemen Programmierung mit Daten empfangen wird, durch Befehle in dem schaltkreisintemen Programmiersatz (40) bestimmt sind.

16. Vorrichtung nach Anspruch 1, einschließlich Programmier- und Löschschaltkreisen (36), die gemeinsam mit den ersten und zweiten Speicherarrays verbunden sind.

17. Vorrichtung nach Anspruch 1, wobei das erste Speicherarray (17) eine Mehrzahl von getrennt löschbaren nicht-flüchtigen Speicherzellen aufweist.

18. Vorrichtung nach Anspruch 1, wobei das erste Speicherarray (17) einen löschbaren und programmierbaren Nur-Lese-Flash-Speicher aufweist.

19. Vorrichtung nach Anspruch 1 oder Anspruch 10, wobei die nicht-flüchtigen Speicherzellen in dem ersten Speicherarray (17) Speicherzellen mit Floating-Gate aufweisen.

20. Vorrichtung nach Anspruch 2 oder Anspruch 10, wobei die nicht-flüchtigen Speicherzellen in dem ersten Speicherarray (17) und in dem zweiten Speicherarray (16) Speicherzellen mit Floating-Gate aufweisen.

21. Vorrichtung nach Anspruch 1 oder Anspruch 10, wobei das erste Speicherarray (17) und das zweite Speicherarray (16) löschbare und programmierbare Nur-Lese-Flash-Speicher aufweisen.

22. Vorrichtung nach Anspruch 1 oder Anspruch 10, wobei der externe Anschluß einen seriellen Anschluß (12) aufweist.

23. Vorrichtung nach Anspruch 1 oder Anspruch 10, wobei der externe Anschluß einen parallelen Anschluß (13) aufweist.

24. Vorrichtung nach Anspruch 1 oder Anspruch 10, mit einer Mehrzahl von Anschlüssen (12, 13) zu einem externen Satz von Datenquellen, wobei der Anschluß in der Mehrzahl von Anschlüssen, welcher für den externen Anschluß während der Ausführung des schaltkreisinternen Programmiersatzes verwendet wird, durch die Befehle in dem schaltkreisinternen Programmiersatz (40) bestimmt ist.

25. Vorrichtung nach Anspruch 1, wobei:
der Prozessor (11) auf dem integrierten Schaltkreis (10) einen Befehlseingang (28) hat und Befehle ausführt, welche an dem Befehlseingang empfangen werden,
das erste Speicherarray (17) nicht-flüchtige Speicherzellen auf dem integrierten Schaltkreis aufweist, der einen Leseanschluß (25) hat, welcher mit dem Befehlseingang des Prozessors verbunden ist, und einen Block nicht-flüchtiger Speicherzellen, welcher den schaltkreisinternen Programmiersatz von Befehlen (40) speichert,
das zweite Speicherarray nicht-flüchtige Speicherzellen auf dem integrierten Schaltkreis aufweist und einen Leseanschluß (24) hat, der mit dem Befehlseingang des Prozessors verbunden ist, und
die Vorrichtung weiterhin Datenpfade (20, 21) auf dem integrierten Schaltkreis aufweist, um das erste Speicherarray unabhängig von dem schaltkreisinternen Programmiersatz zu programmieren und zu verifizieren.

26. Vorrichtung nach Anspruch 25, wobei die nicht-flüchtigen Speicherzellen in dem ersten Speicherarray (17) und in dem zweiten Speicherarray (16) Speicherzellen mit Floating-Gate aufweisen.

27. Vorrichtung nach Anspruch 25, wobei das erste Speicherarray (17) eine Mehrzahl getrennt löschbarer Blöcke nicht-flüchtiger Speicherzellen aufweist und wobei der schaltkreisinteme Programmiersatz in einem bestimmten Block in der Mehrzahl von Blöcken gespeichert ist, und wobei während der Ausführung des schaltkreisintemen Programmiersatzes aus dem zweiten Speicherarray (16) der bestimmte Block modifiziert wird, um einen neuen schaltkreisinternen Programmiersatz zu erzeugen, und dann die Steuerlogik so betreibbar ist, daß sie den Prozessor veranlaßt, den neuen schaltkreisintemen Programmiersatz aus dem ersten Speicherarray auszuführen.

28. Vorrichtung nach Anspruch 25, wobei das erste Speicherarray (17) und das zweite Speicherarray (16) löschbare und programmierbare Nur-Lese-Flash-Speicher aufweisen.

29. Vorrichtung nach Anspruch 25, wobei die Steuerlogik Befehle enthält, die durch den Prozessor (11) ausgeführt werden.

30. Vorrichtung nach Anspruch 25, wobei der externe Anschluß einen seriellen Anschluß (12) aufweist.

31. Vorrichtung nach Anspruch 25, wobei der externe Anschluß einen Parallelanschluß (13) aufweist.

32. Vorrichtung nach Anspruch 25, mit einer Mehrzahl von Anschlüssen (12, 13) an externe Datenquellen, wobei derjenige Anschluß aus der Mehrzahl von Anschlüssen, welcher während der Ausführung des schaltkreisintemen Programmiersatzes als externer Anschluß verwendet wird, durch die Befehle in dem schaltkreisintemen Programmierungssatz (40) festgelegt ist.

33. Vorrichtung nach Anspruch 25, wobei die nicht-flüchtigen Speicherzellen in dem ersten Speicherarray (17) Speicherzellen mit Floating-Gate aufweisen, und wobei das zweite Speicherarray (16) Speicherzellen mit Floating-Gate aufweisen, und mit:
einem Lösch- und Programmieranschluß (36), welcher mit den ersten und zweiten Speicherarrays verbunden ist, welcher ein Löschen und Programmieren der ersten und zweiten Speicherarrays gewährleistet.

34. Vorrichtung nach Anspruch 33, wobei der Lösch- und Programmieranschluß (36) Lösch- und Programmierschaltkreise aufweist, die gemeinsam mit den ersten und zweiten Speicherarrays verbunden sind.

35. Vorrichtung nach Anspruch 33, wobei der Lösch- und Programmieranschluß (36) getrennte Lösch- und Programmierschaltkreise jeweils für die ersten und zweiten Speicherarrays aufweist.

36. Verfahren für das schaltkreisinteme Programmieren eines integrierten Schaltkreises (10), mit einem Prozessor (11), der ein aus Befehlen bestehendes Programm ausführt, wobei das Verfahren die Schritte aufweist:
Bereitstellen eines ersten Speicherarrays (17), welches nicht-flüchtige Speicherzellen aufweist, sowie eines zweiten Speicherarrays (16), welches nicht-flüchtige Speicherzellen aufweist, auf dem integrierten Schaltkreis,
Speichern eines schaltkreisintemen Programmiersatzes von Befehlen (40) in dem ersten Array,
Empfangen (201) eines schaltkreisinternen Programmierbefehls von einem Auslöser bzw. einer Auslöseeinrichtung, die sich außerhalb des integrierten Schaltkreises befindet,
Kopieren (215) des schaltkreisintemen Programmiersatzes (40) von dem ersten Array (17) in das zweite Array (16) und Ausführen (219) des schaltkreisintemen Programmiersatzes aus dem zweiten Array mit dem Prozessor in Reaktion auf den schaltkreisintemen Programmierbefehl,
Programmieren (220) zumindest eines ausgewählten Abschnitts des ersten Arrays mit Daten aus einer externen Quelle unter der Steuerung des schaltkreisinternen Programmiersatzes aus dem zweiten Array, um zumindest den schaltkreisintemen Programmiersatz von Befehlen, welche in dem ersten Array gespeichert sind, zu aktualisieren, und
nach dem Programmieren des Abschnitts des ersten Arrays Ausführen (221) des aktualisierten schaltkreisintemen Programmiersatzes aus dem ersten Array (17) mit dem Prozessor.

37. Verfahren nach Anspruch 36, wobei das erste Array eine Mehrzahl von getrennt löschbaren Blöcken von Zellen aufweist, und wobei der ausgewählte Abschnitt des ersten Arrays einen besonderen Block in der Mehrzahl von Blöcken aufweist, und wobei der Schritt des Programmierens (220) des Abschnitts des ersten Arrays das Modifizieren des speziellen Blocks umfaßt, so daß er einen neuen, schaltkreisinternen Programmiersatz erzeugt.

38. Verfahren nach Anspruch 37 mit:
nach dem Modifizieren des bestimmten Blocks Ausführen (221) des neuen, schaltkreisinternen Programmiersatzes aus dem ersten Speicherarray.

39. Verfahren nach Anspruch 36, welches weiterhin die Schritte aufweist:
bei dem Empfangsschritt (201) zusätzliches Empfangen einer Kennung von der Ausleseeinrichtung, die sich außerhalb des integrierten Schaltkreises befindet,
Verifizieren (201) der Kennung der Ausleseeinrichtung, und, falls die Verifizierung erfolgt ist, Durchführen des Kopierschrittes (215) in Reaktion auf den schaltkreisintemen Programmierbefehl, um den schaltkreisinternen Programmiersatz aus dem ersten Array in das zweite Array zu kopieren, und Durchführen des Ausführungsschritts (219), um mit dem Prozessor den schaltkreisintemen Programmiersatz aus dem zweiten Array (16) durchzuführen.

40. Verfahren nach Anspruch 39, welches umfaßt:
falls die Kennung der Ausleseeinrichtung nicht verifiziert wird, Anfordern (205) der Identifizierung von der Ausleseeinrichtung und Versuchen, die Identifizierung der Ausleseeinrichtung zu verifizieren (202), bis die Verifizierung erfolgreich abgeschlossen ist, oder bis eine maximale Anzahl an Versuchen durchgeführt wurde (203), und
falls die maximale Anzahl an Versuchen durchgeführt wurde, Ausgeben (204) einer Antwort über das Fehlschlagen an die Ausleseeinrichtung.

41. Verfahren nach Anspruch 39, welches aufweist:
Ausgeben (206) einer Änderungsnummer, um den Befehlssatz zu kennzeichnen, und Speichern (228) der Änderungsnummer, falls der Schritt des Programmierens erfolgreich abläuft.

42. Verfahren nach Anspruch 39, welches aufweist:
nach dem Schritt des Programmierens Überprüfen (227) des programmierten Befehlssatzes auf Fehler, und, falls ein Fehler gefunden wird, emeutes Versuchen des Programmierschritts, bis keine Fehler mehr gefunden werden oder bis eine maximale Anzahl von wiederholten Versuchen durchgeführt worden ist (231), und,
falls die maximale Anzahl an Versuchen durchgeführt worden ist, Ausgeben (232) einer Fehlerantwort an die Ausleseeinrichtung.

43. Verfahren nach Anspruch 42, wobei der Schritt des Überprüfens des programmierten Befehlssatzes auf Fehler das Verifizieren (227) einer Prüfsumme für den programmierten Befehlssatz umfaßt.

44. Verfahren nach Anspruch 39, wobei der Schritt des Programmierens das Programmieren (307) eines Segments des Befehlssatzes und das Verifizieren (308) des Programmierens des Segments umfaßt, und, falls das Programmieren des Segments verifiziert wurde, Weitergehen (311) zu einem nächsten Segment, bis der Befehlssatz abgeschlossen ist, und, falls das Programmieren des Segments nicht verifiziert wurde, erneutes Versuchen des Programmierens, bis dieses die Verifizierung erfolgreich durchlaufen hat, oder bis eine maximale Anzahl erneuter Versuche ausgeführt worden ist (309),
falls die maximale Anzahl erneuter Versuche ausgeführt worden ist, ohne erfolgreiche Verifizierung, Ausgeben (310) einer Fehlernachricht an die Auslöseeinrichtung.

45. Verfahren nach Anspruch 39, wobei das erste Array (17) eine Mehrzahl von getrennt löschbaren Blöcken von Zellen aufweist, und wobei ein ausgewählter Abschnitt des ersten Arrays einen bestimmten Block in der Mehrzahl von Blöcken aufweist, und wobei der Schritt des Programmierens (220) des Abschnitts des ersten Arrays das Modifizieren des bestimmten Blocks umfaßt, um einen neuen, schaltkreisinternen Programmiersatz zu erzeugen.

46. Verfahren nach Anspruch 45, welches aufweist:
nach dem Modifizieren des bestimmten Blocks, Ausführen (221) des neuen, schaltkreisinternen Programmiersatzes aus dem ersten Speicherarray.

47. Verfahren nach Anspruch 36 oder 39, wobei der Schritt des Speichems des schaltkreisinternen Programmiersatzes das Speichern des schaltkreisintemen Programmiersatzes in dem ausgewählten Abschnitt des ersten Arrays (17) aufweist.

48. Verfahren nach Anspruch 36 oder 39, welches aufweist:
Bestimmen aus der Ausleseeinrichtung, ob die schaltkreisinteme Programmiersequenz, welche durch den schaltkreisinternen Befehl angezeigt wurde, das Modifizieren (213) des schaltkreisintemen Programmiersatzes umfaßt, und, falls nicht, Auslassen des Schrittes des Kopierens und Ausführen des schaltkreisintemen Programmiersatzes aus dem zweiten Array.

49. Verfahren nach Anspruch 36 oder 39, wobei der integrierte Schaltkreis eine Mehrzahl von Anschlüssen (12, 13) zu externen Datenquellen aufweist, und wobei der Schritt des Programmierens das Empfangen von Daten von einem ausgewählten Anschluß aus der Mehrzahl von Anschlüssen umfaßt.

50. Verfahren nach Anspruch 49, wobei der ausgewählte Anschluß durch den schaltkreisinternen Programmiersatz (40) angegeben wird.

51. Verfahren nach Anspruch 36 oder 39, wobei das erste Array (17) und das zweite Array (16) löschbare und programmierbare Nur-Lese-Speicherzellen aufweisen.

## Revendications

1. Appareil pour la programmation en circuit d'un circuit intégré (10) ayant un processeur (11) qui exécute un programme d'instructions, comprenant :
une première matrice mémoire (17) comprenant des cellules de mémoire non volatile sur le circuit intégré qui stocke des instructions à exécuter par le processeur, incluant un ensemble de programmation en circuit d'instructions (40) pour la programmation de la première matrice mémoire ;
une deuxième matrice mémoire (16) comprenant des cellules de mémoire non volatile sur le circuit intégré qui stocke des instructions à exécuter par le processeur ;
un port externe (12, 13) sur le circuit intégré par lequel des données sont reçues d'une source externe ; et
une logique de commande, sensible à une instruction d'actualisation de programmation en circuit, pour écrire une copie de l'ensemble de programmation en circuit (40) de la première matrice mémoire (17) sur la deuxième matrice mémoire (16) et pour conduire le processeur (11) à exécuter l'ensemble de programmation en circuit à partir de la deuxième matrice mémoire (16) pour programmer des cellules de mémoire non volatile de la première matrice mémoire (17) avec des données provenant du port externe afin d'actualiser au moins l'ensemble de programmation en circuit d'instructions stockées dans la première matrice mémoire, après quoi la logique de commande est utilisable pour conduire le processeur à exécuter l'ensemble de programmation en circuit actualisé d'instructions stockées dans la première matrice mémoire.

2. Appareil selon la revendication 1, dans lequel la première matrice mémoire (17) comprend une pluralité de blocs de cellules de mémoire non volatile effaçables séparément, et l'ensemble de programmation en circuit est stocké dans un bloc particulier parmi la pluralité de blocs, et dans lequel, pendant l'exécution de l'ensemble de programmation en circuit à partir de la deuxième matrice mémoire (16), le bloc particulier est modifié pour générer un nouvel ensemble de programmation en circuit, et la logique de commande est ensuite utilisable pour conduire le processeur à exécuter le nouvel ensemble de programmation en circuit à partir de la première matrice mémoire.

3. Appareil selon la revendication 1, comprenant :
un chemin de données (20, 21) pour programmer et vérifier la première matrice mémoire indépendamment de l'ensemble de programmation en circuit.

4. Appareil selon la revendication 1, dans lequel la logique de commande comprend des instructions exécutées par le processeur (11).

5. Appareil selon la revendication 1, comprenant une pluralité de ports (12, 13) sur des sources de données externes et dans lequel l'instruction d'actualisation de programmation en circuit est reçue sur l'un des ports de la pluralité de ports.

6. Appareil selon la revendication 5, dans lequel le port parmi la pluralité de ports utilisé pour le port externe et le port parmi la pluralité de ports sur lequel est reçue l'instruction d'actualisation de programmation en circuit sont déterminés par des instructions dans l'ensemble de programmation en circuit (40).

7. Appareil selon la revendication 1, dans lequel les cellules de mémoire non volatile dans la première matrice mémoire (17) comprennent des cellules de mémoire à grille flottante, et la deuxième matrice mémoire (16) comprend des cellules de mémoire à grille flottante, et comprenant :
un port d'effacement et de programmation (36) couplé aux première et deuxième matrices mémoires, qui assure l'effacement et la programmation des première et deuxième matrices mémoires.

8. Appareil selon la revendication 7, dans lequel le port d'effacement et de programmation (36) comprend des circuits d'effacement et de programmation connectés en commun aux première et deuxième matrices mémoires.

9. Appareil selon la revendication 7, dans lequel le port d'effacement et de programmation (36) comprend des circuits d'effacement et de programmation séparés pour chacune des première et deuxième matrices mémoires.

10. Appareil selon la revendication 1, comprenant de plus :
un multiplexeur de codage (26) ayant une première entrée couplée à la première matrice mémoire (17), une deuxième entrée couplée à la deuxième matrice mémoire (16) et une sortie (28) pour délivrer des instructions au processeur (11) ;
un multiplexeur d'effacement et de programmation (30) qui supporte un premier chemin d'effacement et de programmation (20) servant à programmer et à effacer au moins la première matrice mémoire (17) pour charger au moins la première matrice mémoire en instructions et un deuxième chemin d'effacement et de programmation (38) servant à programmer et à effacer au moins la première matrice mémoire (17) sous la commande de l'ensemble de programmation en circuit d'instructions (40) ; et
une logique comprenant l'ensemble de programmation en circuit d'instructions stockées dans la première matrice mémoire et le processeur, sensible à l'instruction d'actualisation de programmation en circuit pour actualiser la totalité ou une partie des instructions stockées dans la première matrice mémoire et dans la deuxième matrice mémoire.

11. Appareil selon la revendication 10, dans lequel l'ensemble de programmation en circuit d'instructions comprend une logique pour :
écrire une copie de l'ensemble de programmation en circuit original (40) de la première matrice mémoire (17) sur la deuxième matrice mémoire (16) pour créer un ensemble de programmation en circuit en miroir ;
commander le multiplexeur de codage (26) pour commuter la commande du processeur (11) de l'ensemble de programmation en circuit original sur l'ensemble de programmation en circuit en miroir dans la deuxième matrice mémoire ; et
actualiser l'ensemble de programmation en circuit dans la première matrice mémoire sous la commande de l'ensemble de programmation en circuit en miroir dans la deuxième matrice mémoire.

12. Appareil selon la revendication 10, comprenant des circuits d'effacement et de programmation (36) couplés en commun aux première et deuxième matrices mémoires.

13. Appareil selon la revendication 10, dans lequel la première matrice mémoire (17) comprend une pluralité de blocs de cellules de mémoire non volatile effaçables séparément.

14. Appareil selon la revendication 10, comprenant une pluralité de ports (12, 13) sur des sources de données externes et dans lequel l'instruction d'actualisation de programmation en circuit est reçue sur l'un des ports de la pluralité de ports.

15. Appareil selon la revendication 14, dans lequel le port parmi la pluralité de ports utilisé pour le port externe et le port parmi la pluralité de ports sur lequel est reçu le programme en circuit avec une instruction de données sont déterminés par des instructions dans l'ensemble de programmation en circuit (40).

16. Appareil selon la revendication 1, comprenant des circuits de programmation et d'effacement (36) couplés en commun aux première et deuxième matrices mémoires.

17. Appareil selon la revendication 1, dans lequel la première matrice mémoire (17) comprend une pluralité de blocs de cellules de mémoire non volatile effaçables séparément.

18. Appareil selon la revendication 1, dans lequel la première matrice mémoire (17) comprend une mémoire morte programmable et effaçable flash.

19. Appareil selon la revendication 1 ou la revendication 10, dans lequel les cellules de mémoire non volatile dans la première matrice mémoire (17) comprennent des cellules de mémoire à grille flottante.

20. Appareil selon la revendication 2 ou la revendication 10, dans lequel les cellules de mémoire non volatile dans la première matrice mémoire (17) et dans la deuxième matrice mémoire (16) comprennent des cellules de mémoire à grille flottante.

21. Appareil la revendication 1 ou la revendication 10, dans lequel la première matrice mémoire (17) et la deuxième matrice mémoire (16) comprennent une mémoire morte programmable et effaçable flash.

22. Appareil la revendication 1 ou la revendication 10, dans lequel le port externe comprend un port série (12).

23. Appareil la revendication 1 ou la revendication 10, dans lequel le port externe comprend un port parallèle (13).

24. Appareil selon la revendication 1 ou la revendication 10, comprenant une pluralité de ports (12, 13) sur des sources de données de réglage externes et dans lequel le port, parmi la pluralité de ports, utilisé pour le port externe pendant l'exécution de l'ensemble de programmation en circuit est déterminé par les instructions dans l'ensemble de programmation en circuit (40).

25. Appareil la revendication 1, dans lequel :
le processeur (11) sur le circuit intégré (10) a une entrée d'instruction (28) et exécute des instructions reçues à l'entrée d'instruction ;
la première matrice mémoire (17) comprend des cellules de mémoire non volatile sur le circuit intégré ayant un port de lecture (25) couplé à l'entrée d'instruction du processeur et un bloc de cellules de mémoire non volatile stockant l'ensemble de programmation en circuit d'instructions (40) ;
la deuxième matrice mémoire comprend des cellules de mémoire non volatile sur le circuit intégré ayant un port de lecture (24) couplé à l'entrée d'instruction du processeur ; et
l'appareil comprenant de plus des chemins de données (20, 21), sur le circuit intégré, pour programmer et vérifier la première matrice mémoire indépendamment de l'ensemble de programmation en circuit.

26. Appareil selon la revendication 25, dans lequel les cellules de mémoire non volatile dans la première matrice mémoire (17) et dans la deuxième matrice mémoire (16) comprennent des cellules de mémoire à grille flottante.

27. Appareil selon la revendication 25, dans lequel la première matrice mémoire (17) comprend une pluralité de blocs de cellules de mémoire non volatile effaçables séparément, et l'ensemble de programmation en circuit est stocké dans un bloc particulier dans la pluralité de blocs, et dans lequel, pendant l'exécution de l'ensemble de programmation en circuit à partir de la deuxième matrice mémoire (16), le bloc particulier est modifié pour générer un nouvel ensemble de programmation en circuit, et la logique de commande est ensuite utilisable pour conduire le processeur à exécuter le nouvel ensemble de programmation en circuit à partir de la première matrice mémoire.

28. Appareil selon la revendication 25, dans lequel la première- matrice mémoire (17) et la deuxième matrice mémoire (16) comprennent une mémoire morte programmable et effaçable flash.

29. Appareil selon la revendication 25, dans lequel la logique de commande comprend des instructions exécutées par le processeur (11).

30. Appareil selon la revendication 25, dans lequel le port externe comprend un port série (12).

31. Appareil selon la revendication 25, dans lequel le port externe comprend un port parallèle (13).

32. Appareil selon la revendication 25, comprenant une pluralité de ports (12, 13) sur des sources de données externes et dans lequel le port, parmi la pluralité de ports, utilisé pour le port externe pendant l'exécution de l'ensemble de programmation en circuit est déterminé par des instructions dans l'ensemble de programmation en circuit (40).

33. Appareil selon la revendication 25, dans lequel les cellules de mémoire non volatile dans la première matrice mémoire (17) comprennent des cellules de mémoire à grille flottante, et la deuxième matrice mémoire (16) comprend des cellules de mémoire à grille flottante, et comprenant :
un port d'effacement et de programmation (36) couplé aux première et deuxième matrices mémoires, qui assure l'effacement et la programmation des première et deuxième matrices mémoires.

34. Appareil selon la revendication 33, dans lequel le port d'effacement et de programmation (36) comprend des circuits d'effacement et de programmation connectés en commun aux première et deuxième matrices mémoires.

35. Appareil selon la revendication 33, dans lequel le port d'effacement et de programmation (36) comprend des circuits d'effacement et de programmation séparés pour chacune des première et deuxième matrices mémoires.

36. Procédé pour la programmation en circuit d'un circuit intégré (10) ayant un processeur (11) qui exécute un programme d'instructions, comprenant les étapes qui consistent à :
fournir sur le circuit intégré une première matrice mémoire (17) comprenant des cellules de mémoire non volatile et une deuxième matrice mémoire (16) comprenant des cellules de mémoire non volatile ;
stocker un ensemble de programmation en circuit d'instructions (40) dans la première matrice ;
recevoir (201) une instruction de programmation en circuit à partir d'un initiateur externe au circuit intégré ;
copier (215), en réponse à l'instruction de programmation en circuit, l'ensemble de programmation en circuit (40) de la première matrice (17) sur la deuxième matrice (16) et à exécuter (219), avec le processeur, l'ensemble de programmation en circuit à partir de la deuxième matrice ;
programmer (220) au moins une partie sélectionnée de la première matrice avec des données provenant d'une source externe sous la commande de l'ensemble de programmation en circuit à partir de la deuxième matrice afin d'actualiser au moins l'ensemble de programmation en circuit d'instructions stockées dans la première matrice mémoire ; et
exécuter (221), après la programmation de la partie de la première matrice, l'ensemble de programmation en circuit actualisé à partir de la première matrice (17), avec le processeur.

37. Procédé selon la revendication 36, dans lequel la première matrice (17) comprend une pluralité de blocs de cellules effaçables séparément, et la partie sélectionnée de la première matrice comprend un bloc particulier dans la pluralité de blocs, et l'étape consistant à programmer (220) la partie de la première matrice comprend la modification du bloc particulier pour générer un nouvel ensemble de programmation en circuit.

38. Procédé selon la revendication 37, comprenant :
après la modification du bloc particulier, l'exécution (221) du nouvel ensemble de programmation en circuit à partir de la première matrice mémoire.

39. Procédé selon la revendication 36, comprenant de plus les étapes qui consistent à :
recevoir également, à ladite étape de réception (201), un identificateur de l'initiateur externe au circuit intégré ;
vérifier (202) l'identificateur de l'initiateur et, s'il est alors vérifié en réponse à l'instruction de programmation en circuit, à réaliser ladite étape de copie (215) pour copier l'ensemble de programmation en circuit de la première matrice sur la deuxième matrice, et à réaliser ladite étape d'exécution (219) pour exécuter, avec le processeur, l'ensemble de programmation en circuit à partir de la deuxième matrice (16).

40. Procédé selon la revendication 39, comprenant les étapes qui consistent à :
si l'identificateur de l'initiateur n'est pas vérifié, demander (205) alors l'identification de l'initiateur et à tenter de vérifier (202) l'identification de l'initiateur jusqu'à ce que la vérification réussisse ou jusqu'à ce qu'un nombre maximum de tentatives ait été réalisé (203) ; et
si le nombre maximum de tentatives est réalisé, délivrer (204) alors une réponse de dérangement à l'initiateur.

41. Procédé selon la revendication 39, comprenant l'étape qui consiste à :
délivrer (206) un numéro de révision pour identifier l'ensemble d'instructions et à stocker (228) le numéro de révision si l'étape de programmation réussit.

42. Procédé selon la revendication 39, comprenant les étapes qui consistent à :
contrôler (227), après l'étape de programmation, les erreurs sur l'ensemble d'instructions programmé et, si une erreur est trouvée, à réessayer alors l'étape de programmation jusqu'à ce qu'aucune erreur ne soit trouvée ou jusqu'à ce qu'un nombre maximum de nouveaux essais ait été tenté (231) ; et
si le nombre maximum de nouveaux essais est tenté, délivrer (232) alors une réponse de dérangement à l'initiateur.

43. Procédé selon la revendication 42, dans lequel l'étape consistant à contrôler les erreurs sur l'ensemble d'instructions programmé comprend la vérification (227) d'un total de contrôle pour l'ensemble d'instructions programmé.

44. Procédé selon la revendication 39, dans lequel l'étape de programmation consiste à programmer (307) un segment de l'ensemble d'instructions et à vérifier (308) la programmation du segment, et si la programmation du segment est vérifiée, à passer (311) à un segment suivant jusqu'à ce que l'ensemble d'instructions soit achevé, et si la programmation du segment n'est pas vérifiée, à réessayer la programmation jusqu'à ce qu'elle passe la vérification ou jusqu'à ce qu'un nombre maximum de nouveaux essais ait été tenté (309) ;
si le nombre maximum de nouveaux essais est tenté sans passer la vérification, à délivrer (310) alors une réponse de dérangement à l'initiateur.

45. Procédé selon la revendication 39, dans lequel la première matrice (17) comprend une pluralité de blocs de cellules de mémoire non volatile effaçables séparément, et la partie sélectionnée de la première matrice comprend un bloc particulier dans la pluralité de blocs, et l'étape consistant à programmer (220) la partie de la première matrice comprend la modification du bloc particulier pour générer un nouvel ensemble de programmation en circuit.

46. Procédé selon la revendication 45, comprenant :
après la modification du bloc particulier, l'exécution (221) du nouvel ensemble de programmation en circuit à partir de la première matrice mémoire.

47. Procédé selon la revendication 36 ou la revendication 39, dans lequel l'étape consistant à stocker l'ensemble de programmation en circuit comprend le stockage de l'ensemble de programmation en circuit dans la partie sélectionnée de la première matrice (17).

48. Procédé selon la revendication 36 ou la revendication 39, comprenant l'étape qui consiste à :
déterminer à partir de l'initiateur si la séquence de programmation en circuit indiquée par l'instruction de programmation en circuit comprend la modification (213) de l'ensemble de programmation en circuit et, si ce n'est pas le cas, à passer à l'étape consistant à copier et à exécuter l'ensemble de programmation en circuit à partir de la deuxième matrice.

49. Procédé selon la revendication 36 ou la revendication 39, dans lequel le circuit intégré comprend une pluralité de ports (12, 13) sur des sources de données externes et l'étape de programmation comprend la réception de données à partir d'un port sélectionné parmi la pluralité de ports.

50. Procédé selon la revendication 49, dans lequel le port sélectionné est spécifié par l'ensemble de programmation en circuit (40).

51. Procédé selon la revendication 36 ou la revendication 39, dans lequel la première matrice (17) et la deuxième matrice (16) comprennent des cellules de mémoire morte programmable et effaçable.
